# EUROPEAN PATENT APPLICATION

(11) **EP 4 788 101 A1**
(43) Date of publication of application: **05.08.2026**
(21) Application number: 25155371.5
(22) Date of filing: 31.01.2025
(51) Int. Cl.: H10K 50/115, B60Q 3/80

(54) **LIGHTING DEVICE COMPRISING A SEGMENT WITH AT LEAST ONE QLED**

(71) Applicant: Valeo Vision, 93012 Bobigny Cedex (FR)
(72) Inventor: SANTAELLA, Juan-Jose, 23600 MARTOS (ES)
(74) Representative: Valeo Visibility

(57) **Abstract**

The invention relates to a lighting device (1), wherein said lighting device (1) comprising :
- at least one segment (10) comprising at least one QLed (11), said at least one QLed (11) being configured to generate a monochromatic light beam (b) and being composed of one cathode (110), one anode (111), carrier transport layers (112), at least one active Quantum dots layer (113), and one substrate (114),
- one driver (13) that is configured to control said at least one QLed (11) by applying an electrical power (P) so that said at least one QLed (11) generates said monochromatic light beam (b).

## Description

The present invention relates to a lighting device. Such a lighting device may be used, but not exclusively, in the automotive domain.

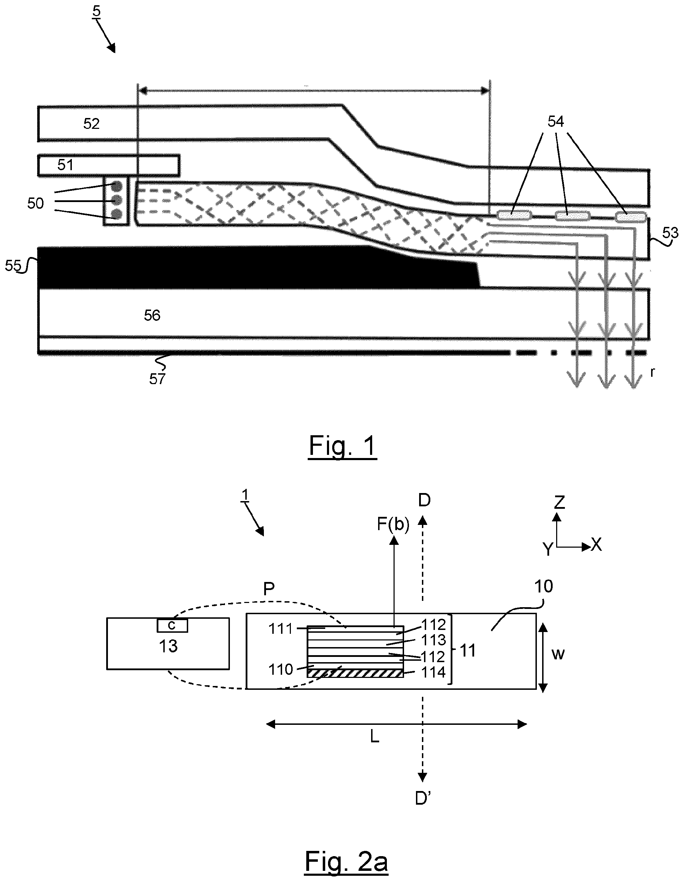

In the automotive domain, as illustrated in figure 1, a lighting device 5 of the prior art comprises at least one light source 50 that is configured to emit light rays according to a first range of wavelengths. The lighting device 5 provides some light for the interior lighting or for lighting modules such as a headlamp or a rear lamp, or any other lighting modules for the vehicle. The light source is usually a RGB Light Emitting Diode ("LED") or a laser light source. The RGB Light Emitting Diode is a multi-source with three R "Red", G "Green"and B "Blue" emitters. The lighting device 5 further comprises :
- an electronic support 51 for the at least one light source 50,
- a white housing 52 that is a plastic holder,
- a lightguide 53 that is configured to guide the light rays r from said at least one light source 50,
- optical cones 54 in backside that form a reflective area to orientate the light rays R in a normal direction,
- a bezel carrier 55 that is opaque that is arranged opposite to the lightguide 53 along a part of the lightguide 53 where there is no reflective area,
- a diffusive foil 56 that is configured to diffuse the light coming from the lightguide 52 in order to have a homogenous light, and
- a decorative element 57 that permits to form a final pattern.
The diffusive foil is formed through a thermoform process that uses an overmolded process.

One problem of this prior art is that in order to have a high level of light homogeneity, there is a need to add the diffuser foil 56, but the result is a low optical and electrical efficiency, as the diffuser 56 permits only 35% of transmission of the light rays r.

It is an object of the invention to provide a lighting device, which resolves the problem above-stated.

To this end, it is provided a lighting device, said lighting device comprising :
- at least one segment comprising at least one QLed, said at least one QLed being configured to generate a monochromatic light beam and being composed of one cathode, one anode, carrier transport layers, at least one active Quantum dots layer, and one substrate,
- one driver that is configured to control said at least one QLed by applying an electrical power so that said at least one QLed generates said monochromatic light beam.

As we will see in further details, thanks to the use of the Qled(s) in at least one segment of the lighting device, one removes the diffusive foil that hinders the transmission of the light. Moreover, with the Qled(s), one has a direct emergent light and not an indirect one like the prior art, which enhances the light efficiency of the lighting device.

According to non-limitative embodiments of the invention, the lighting device in accordance with the invention further comprises the following characteristics.

In a non-limitative embodiment, said at least one segment comprises a plurality of QLeds.

In a non-limitative embodiment, said at least one segment comprises three QLeds.

In a non-limitative embodiment, each QLed is configured to generate a monochromatic light beam of a same color of all the other QLeds, or a monochromatic light beam of a different color of at least another QLeds.

In a non-limitative embodiment, the monochromatic light beams are a combination of blue, red, and/or green, or a combination of yellow, magenta, and/or cyan.

In a non-limitative embodiment, said lighting device comprises a plurality of segments with at least one QLed or a plurality of QLed.

In a non-limitative embodiment, the driver is a multichannel driver, each channel being configured to control at least one QLed individually.

In a non-limitative embodiment, said monochromatic light beam is generated in at least one selective direction, said at least one selective direction depending on the material(s) of the cathode and anode.

In a non-limitative embodiment, the cathode and the anode are of the same material or are of different materials.

In a non-limitative embodiment, the material(s) is a transparent or translucent material(s), or an opaque material(s) or a reflective material.

In a non-limitative embodiment, the electrical power applied on said at least one segment is modulated according to a PWM modulation.

In a non-limitative embodiment, said driver is integrated in said substrate.

In a non-limitative embodiment, said lighting device further comprises a decorative element to form a pattern or is directly adjacent to a decorative element.

In a non-limitative embodiment, said lighting device is a lighting device for a vehicle.

In a non-limitative embodiment, the quantum dots are synthesized in the form of colloidal solutions.

There is also provided a lighting module, said lighting module comprising a lighting device according to any of the preceding characteristics, a housing that is configured to house said lighting device, and a carrier.

In a non-limitative embodiment, said lighting module is a lighting module of a vehicle.

In a non-limitative embodiment, said lighting module is a lamp of the vehicle, or a dashboard lighting module, or an interior element of the vehicle.

In a non-limitative embodiment, said lamp of the vehicle is a headlamp or a rear lamp.

In a non-limitative embodiment, said interior element of the vehicle is the roof, or the control panel, or a handle, or part of a door, or a dome element, or a projection element.

Some embodiments of methods and/or apparatus in accordance with embodiments of the present invention are now described, by way of example only, and with reference to the accompanying drawings, in which:
Figure 1 is a schematic diagram that illustrates a lighting device of the prior art,
Figure 2a is a schematic diagram that illustrates a side view of a lighting device according to a non-limitative embodiment of the invention, said lighting device comprising one segment with one QLed, one substrate, and one driver,
Figure 2b is a schematic diagram that illustrates a side view of a lighting device according to a non-limitative embodiment of the invention, said lighting device comprising one segment with three QLeds, one substrate, and one driver,
Figure 2c is a top view of the lighting device of figure 2b,
Figure 3 is a schematic diagram that illustrates a top view of a lighting device according to a non-limitative embodiment of the invention, said lighting device comprising a plurality of segments with three QLeds, one substrate, and one driver,
Figure 4 is a schematic diagram that illustrates a top view of a lighting device according to a non-limitative embodiment of the invention, said lighting device comprising a plurality of segments with three QLeds, one substrate, and one driver that is integrated into said substrate,
Figure 5 is a schematic diagram of a QLed of figure 3 or 4 according to a first non-limitative embodiment, said QLed comprising an anode, a cathode, carrier transport layers, and one active Quantum dots layer,
Figure 6 is a schematic diagram of a QLed of figure 3 or 4 according to a second non-limitative embodiment, said QLed comprising an anode, a cathode, carrier transport layers, and two active Quantum dots layers,
Figure 7 illustrates the QLed of figure 5, said QLed being configured to generate a monochromatic light beam so as to obtain one selective light output in a first selective direction,
Figure 8 illustrates the QLed of figure 5, said QLed being configured to generate a monochromatic light beam so as to obtain one selective light output in a second selective direction,
Figure 9 illustrates the QLed of figure 5, said QLed being configured to generate a monochromatic light beam so as to obtain two selective light outputs in a first selective direction and in a second selective direction respectively,
Figure 10 illustrates the lighting device of figure 2a, said lighting device further comprising a decorative element,
Figure 11 illustrates the lighting device of figure 2a, said lighting device being adjacent to a decorative element,
Figure 12 is a non-limitative example of a multicolor geometrical pattern obtains with the lighting device of figure 2a, 2b, 3, 4, 9, 10 or 11,
Figure 13 illustrates a sectional view and an exploded view of this sectional view of some parts of a dashboard lighting module comprising the lighting device of figure 2a, 2b, 3, 4, 9, a housing, and a carrier, according to a non-limitative embodiment,

In the following description, well-known functions or constructions by the man skilled in the art are not described in detail since they would obscure the invention in unnecessary detail.

The present invention relates to a lighting device 1, said lighting device 1 being described in reference to figures 2a to 12, according to non-limitative embodiments. In a non-limitative embodiment, the lighting device 1 is a lighting device of a vehicle.

In non-limitative embodiments, the vehicle is a motor vehicle, an electrical vehicle or a hybrid vehicle.

The lighting device 1 provides light for the interior lighting or for lighting modules such as a headlamp or a rear lamp, or any other lighting modules for the vehicle. In non-limitative embodiments, the lighting device 1 is part of a lighting module 20 of the vehicle. In non-limitative examples, the lighting module 20 is :
- any type of lamp such as in non-limitative examples a headlamp, or a rear lamp, or
- a dashboard lighting module, or,
- an interior element of the vehicle. In non-limitative examples, the interior element is the roof, the control panel, a handle, part of a door, a dome light, a projection light, etc.

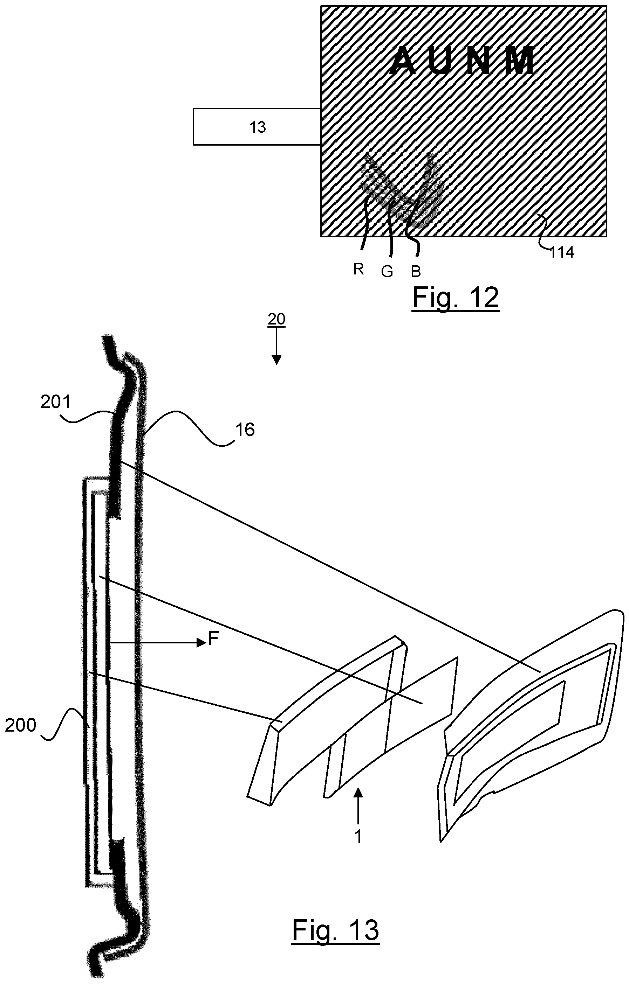

Figure 13 illustrated some elements of a lighting module 20 that is a dashboard lighting module. It comprises a housing 200 and a carrier 201. The housing 200 is configured to receive the lighting device 1. A decorative element 16 described later in the following is also illustrated.

As illustrated in figure 2a to 4, 10, and 11, the lighting device 1 comprises a first direction D and a second direction D' opposed to the first direction D. The first direction D is the direction that is facing the exterior of the vehicle when the lighting device 1 is a headlamp or a rear lamp for example. The first direction D is the direction that is facing the vehicle interior when the lighting device 1 is a dashboard lighting module or an interior element of the vehicle in another example.

The lighting device 1 is configured to emit an emergent light beam F (also called in the following global light beam F) throughout the carrier 201 of the lighting module 20 and the decorative element 16 along the first direction D. Hence, with the different elements of the lighting device 1 described in the following, the lighting device 1 is able to produce the global light beam F that emerges from the lighting device 1 in particular in the visible RGB spectrum. The global light beam F is formed of one or a plurality of different light beams b.

The lighting device 1 extends in height along a vertical direction Z that is parallel to the first direction D and in width along a first horizontal direction X that is perpendicular to the vertical direction X, and in depth along a second horizontal direction Y that is perpendicular to the vertical direction Z and the first horizontal direction X.

As illustrated in figures 2a to 4, 10, and 11, the lighting device 1 comprises :
- at least one segment 10 comprising at least one QLed 11,
- one substrate 114, and
- one driver 13.

These different elements of the lighting device 1 are described in detail in the following.

### Segment 10 and QLed 11:

The lighting device 1 comprises one or a plurality of segments 10. A plurality of segments 10 permits the coverage of a bigger surface/area.

A segment 10 has a width w (illustrated in figure 2a) between nanometers to meters, depending on the surface/area one wants to cover with the segment 10. The width w extends along the vertical direction Z. A segment 10 has a length L (illustrated in figure 2a) between nanometers to meters, depending on the surface/area one wants to cover with the segment 10. The length L extends along the horizontal direction Y.

When there are a plurality of segments 10, in a non-limitative embodiment, the segments 10 have a width w of small dimension (nanometers, micrometers, centimeters) in order to have an homogenous output light when all the segments 10 are put altogether adjacent to each other. When having a small width w (nanometers, micrometers, centimeters), it is flexible to cover different kinds of geometrical shapes (aka geometrical patterns) as illustrated in figure 12. Figure 12 illustrates a logo "AUNM" that is illuminated by the QLed(s) 11 and three curved shapes which are of the colors Red "R", Green "G", and Blue "B".

In a first non-limitative example, the width w is in nanometers for a surface/area such as a screen display of the vehicle. In a second non-limitative example, the width w is in centimeters for a surface/area such as dashboard or small parts of the doors (interior or exterior) of the vehicle. In a third non-limitative example, the width w is in meters for a surface/area such as the roof or exterior surfaces (rear lamps or headlamps).It is to be noted that for the same area, one can add much more segments when the width w is in nanometers. Therefore, one can obtain a high optical resolution.

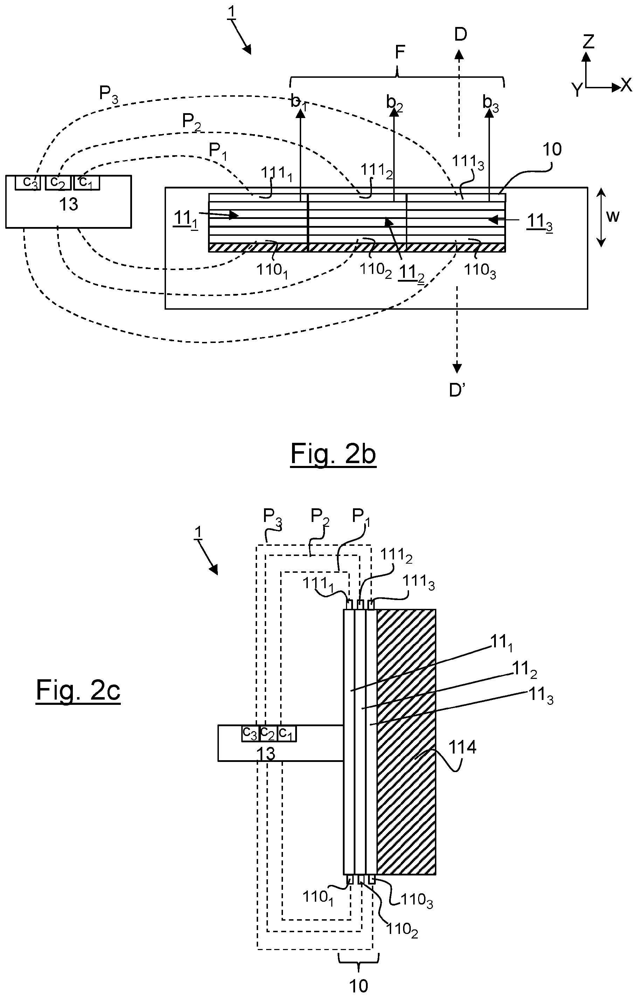

A segment 10 comprises one or a plurality of QLeds 11. In the non-limitative example illustrated in figure 2b and 2c, it comprises three QLeds 11. This permits having the white color when mixing colors of the monochromatic light beams b of the QLeds 11.

In a first non-limitative embodiment illustrated in figure 2a and 2b, the lighting device 1 comprises only one segment 10 with one QLed 11. In a non-limitative example, it is the case when the lighting module 20 where the lighting device 1 is integrated, is a door handle lighting module. In this case, the global light beam F is formed of one light beam b.

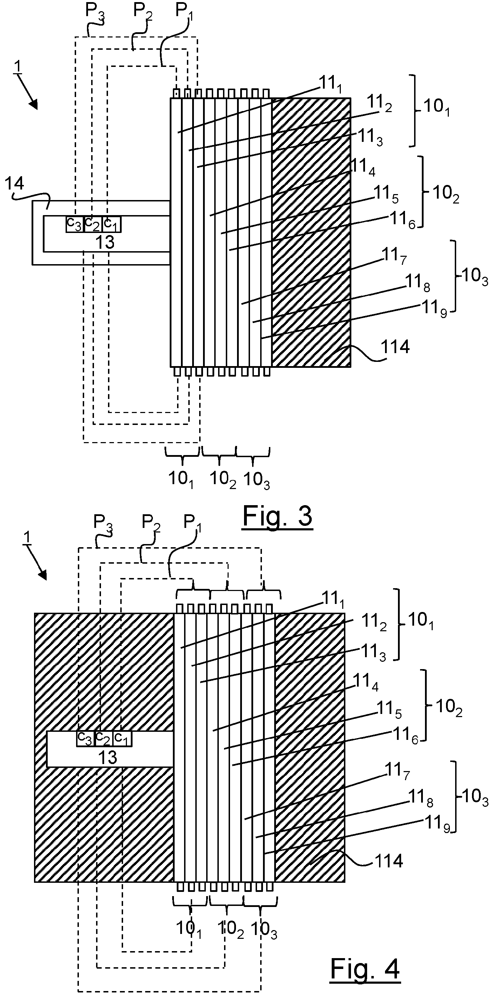

In a second non-limitative embodiment, the lighting device 1 comprises at least two QLeds 11 arranged in one or a plurality of segments 10. In this case, the global light beam F is formed of a plurality of different light beams b. In a non-limitative example, it is the case when the lighting module 20 where the lighting device 1 is integrated, is a dashboard lighting module. In a first non-limitative example illustrated in figures 2b and 2c, the lighting device 1 comprises one segment 10 with three Qleds 11₁, 11₂, 11₃. In a second non-limitative example illustrated in figures 3 and 4, the lighting device 1 comprises three segments 10₁, 10₂, 10₃, each with three QLeds 11₁, 11₂, 11₃, 11₄, 11₅, 11₆, 11₇, 11₈, 11₉ respectively.

A QLed is a Quantum Led. It is a light-emitting diode that uses the Quantum dot technology. A QLed 11 is configured to generate a monochromatic light beam b illustrated in figure 2a, 2b, 10 and 11. Hence, the QLed 11 is monochromatic. Hence, the QLed 11 comprises only one monocolor emitter.

When a segment 10 comprises a plurality of QLeds 11, in a first non-limitative embodiment, each QLed 11 is configured to generate a monochromatic light beam b of the same color of all the other QLeds 11. Hence, the emergent light beam F is of one color. In a second non-limitative embodiment, each QLed 11 is configured to generate a monochromatic light beam b of a different color of at least another QLeds 11. Hence, the emergent light beam F is a mix of colors. In a non-limitative example of three QLeds 11 of figure 2b, the emergent light beam F is of a white color when the monochromatic light beams b₁, b₂, b₃ (illustrated) of each three QLeds 11₁, 11₂, 11₃ are a combination of blue, red, and/or green, or a combination of yellow, magenta, and/or cyan. In other words, In a non-limitative embodiment, the monochromatic light beam b has a first range of wavelengths that corresponds to one of the ranges of the blue light, of the red light, or of the green light, or that corresponds to one of the ranges of the yellow light, of the magenta light, or of the cyan light.

As illustrated in figures 2a, and 5 to 11, a QLed 11 is composed of:
- one cathode 110,
- one anode 111,
- carrier transport layers 112,
- at least one active Quantum dots layer 113,
- a substrate 114.

For the sake of clarity, in figure 2b, the references to the layers 112, 113, and to the substrate 114 have not been illustrated. In a non-limitative embodiment, when a segment 10 comprises a plurality of QLeds 11, the plurality of QLeds 11 can have a common cathode 110 and/or a common anode 111.

The monochromatic light beam b generated by the QLed 11 is generated in at least one selective direction d so as to obtain at least one selective light output, said at least one selective direction depending on the material(s) of the cathode 110 and the anode 111. With the material of the cathode 110 and the anode 111, one can orient the monochromatic light beam generated by all the QLeds 11. The at least one selective direction d is either in the direction D or in the direction D'. Hence, the light is output perpendicular to the substrate 114.

The cathode 110 and the anode 111 are of the same material or of different materials. The material is a transparent or translucent one, or the material is an opaque material or a reflective material. One can have any combination of these materials for the cathode 110 and the anode 111. In a non-limitative example, a transparent material is ITO. In a non-limitative example, an opaque material is a black paint on an ITO. In a non-limitative example, a reflective material is aluminum.

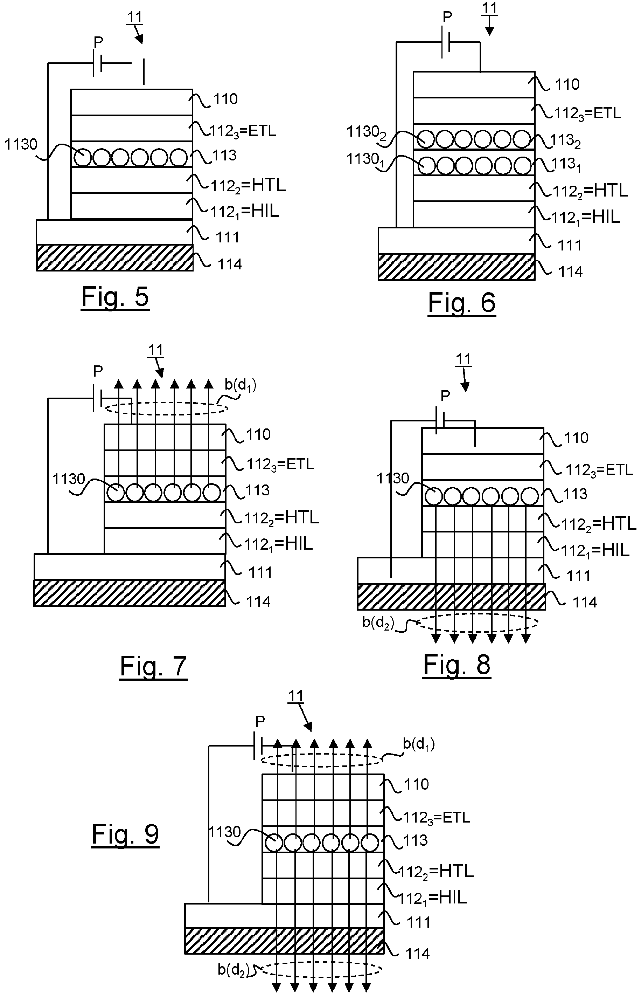

Hence, in a first non-limitative embodiment illustrated in figure 7, the cathode 110 is made of a transparent or a translucent material, and the anode 111 is made of an opaque or a reflective material. Hence, the light beam b generated by the active layer (also called emissive layer), which is the Quantum dots layer 113, is reflected on one side of the Quantum dots layer 113, here the anode 111, and outputs through the transparent side, here the cathode 110. Thus, the output light takes only a first selective direction referenced d₁.

In a second non-limitative embodiment illustrated in figure 8, it is the reverse. The cathode 110 is made of an opaque or a reflective material, and the anode 111 is made of a transparent or translucent material. Hence, the light beam b generated by the emissive layer, which is the Quantum dots layer 113, is reflected on one side of the Quantum dots layer 113, here the cathode 110, and outputs through the transparent side, here the anode 111. Thus, the output light takes only a second selective direction referenced d₂ which is opposite to the first selective direction d₁.

Depending on the manufacture process known by the man skilled in the art and of the carrier transport layers 112, one chooses the cathode 110 or the anode 111 to be transparent.

In a third non-limitative embodiment illustrated in figure 9, it is the reverse. The cathode 110 and the anode 111 are made of a transparent or translucent material. Hence, the light beam b generated by the emissive layer, which is the Quantum dots layer 113, is not reflected on any sides of the Quantum dots layer 113 (neither the cathode 110 nor the anode 111) and outputs through both sides the cathode 110 and the anode 111. Thus, the output light takes the first selective direction d₁ and the second selective direction d₂. Hence, one can create a transparent/translucent lighting device 1 as a whole. It means, you can see through the lighting device 1.

The carrier transport layers 112 are an electron transport layer 112₃ referred to as ETL as illustrated in figures 5 to 9, a hole transport layer 112₂ referred to as HTL, a hole injection layer 112₁ referred to as HIL. In the configuration illustrated in figures 5 to 9 where the anode 111 is adjacent to the substrate 114, the HIL and the HTL are adjacent to each other. The HIL is adjacent to the anode 111. The HTL is adjacent to the Quantum dot layer 113 on one side and the ETL is adjacent to the Quantum dot layer 113 on the other side. Finally, the ETL is adjacent to the cathode 110. These carrier transport layers 112 being known by the man skilled in the art, they won't be described here. In another non-limitative embodiment not illustrated, the QLed 11 comprises a supplementary carrier transport layer 112 which is an electron injection layer referred to as ElL. The EIL is disposed between the ETL and the cathode 110.

In a non-limitative embodiment illustrated in figure 5, the QLed 11 comprises only one active Quantum dots layer 113. An active Quantum dots layer is also called Quantum dots layer 113 or QDs layer 113 in the following. A Quantum dot is also called QD in the following. Having only one Quantum dots layer 113, the thickness of the lighting device 1 is lower and the transparency might be higher.

In another non-limitative embodiment illustrated in figure 6, the QLed 11 comprises a plurality of active Quantum dots layers 113, here two referred to as 113₁ and 113₂. As the Quantum dots are tuned to generate different wavelengths, we can generate a global light beam F as a result with one color that can be mixed with different wavelengths. The light spectrum is mono-wavelengths and pluri-wavelengths.

As illustrated in figure 5 and 6, the one or plurality of QDs layers 113 are disposed between the ETL and HTL layers.

Said active Quantum dots layer 113 is where the light is generated. A QD is an electronic structure obtained out of a semiconductor nanocrystal, with a size such that its electrons and holes are confined in all three spatial dimensions. Depending on the particular sizes of the QDs, they emit light in a particular wavelength when they are excited, either electrically or luminescently. When they are excited, the electrons and holes recombine to generate photons. When the QDs are excited with light, a photoluminescence physical phenomenon occurs. When they are excited by electrical current, which is the case here, electroluminescence physical phenomenon occurs. As a consequence, "Red" quantum dots would be quantum dots which emit light in the red color emission wavelength (also called red color wavelength or simply red wavelength) when excited, "Green" quantum dots would be quantum dots which emit light in the green color emission wavelength (also called green color wavelength or simply green wavelength) when excited, etc. It is the same for other color emission wavelengths such as yellow, orange, etc. One can sweep all monochromatic color wavelengths.

It is to be noted that when the QDs layer 113 is excited, it generates a light beam b that goes in all directions.

As illustrated in figures 5 to 9, the Quantum dots are deposited on a HTL layer. In non-limitative embodiments, the deposit is performed by thin film techniques like spin coating, doctor-blade, ink printing, screening etc.

The QDs are illustrated in the form of circles in figures 5 to 11. For the sake of clarity of the figures, only one QD per Quantum dots layer 113 has been referenced 1130. The QDs are of nanometric size. Hence, even in large surface/area covered by the segment(s) 10, as we are dealing with QD nanometric range, each QD becomes an emitter. As there are millions of them in a reduced area, one can increase the homogeneity of the output light through the surface.

In a non-limitative embodiment, the QDs are synthesized in the form of colloidal solutions. These colloidal solutions are interesting in automotive applications since it is possible to deposit them in large surfaces, using thin film deposition techniques like drop casting, spin coating, spray coating, screen printing, lithography or ink-printing, during the fabrication process. It allows a great flexibility in the design.

In a non-limitative embodiment, each QD comprises a core and a shell or several shells. The QDs acts as the core and is covered with a shell that acts as a passivation element for the core, to increase the quantum confinement and therefore reduce the number of dangling bonds which causes a low value in the QY (quantum yield) parameter.

In a non-limitative embodiment, the core is spherical or pyramidal. In non-limitative embodiments, the core comprises a combination of at least two elements from the list: In, P, Zn, Se, Cu, S, Mn and the shell comprises a combination of at least two elements from the list : Zn, Se and S. These materials have been proven to be suitable for the automotive application.

In non-limitative embodiments, the core/shell quantum dots are formed by CuInS2/ZnS or InP/ZnS. These QDs do not contain heavy metal. They are called Cd-free QDs. These particular materials and their alloys have been proved to be suitable for automotive purposes since they are compliant with international norms applied to automotive components like Global Automotive Declarable Substance List (GADSL) or Restriction of Hazardous Substances (RoHS). Moreover, these particular alloys are able to cover the visible spectrums, and also the invisible spectrum such as near infrared (NIR) or infrared (IR), which is interesting for automotive lighting applications. In addition, these alloys offer high values of photoluminescence quantum yield (PL QY) at low full width half maximum (FWHM) values, which implies a high efficiency and high purity of color achieved. To be more precise, CuInS2 has a spectrum range from green (around 500nm) to infrared (above 700 nm), a photoluminescence quantum yield (PL QY) more than 90% and full width half maximum (FWHM) less than 100 nm. As for InP, we have a spectrum range usually from green (around 500 nm) to red (above 600 nm), a photoluminescence quantum yield (PL QY) more than 85% and full width half maximum (FWHM) less than 50 nm.

In a non-limitative embodiment, the QLed 11 is embedded between two barrier films (not illustrated) for encapsulation purpose. In a non-limitative embodiment, the two barrier films are made of PET (Polyethylene Terephthalate), which confers stability against environmental conditions (temperature, humidity ...) and protection to the QLed 11.

The substrate 114 is the part where the whole QLed 11 is built. It supports the anode 111, the QDs layer 113, the carrier transport layers 112 and the cathode 110.

Depending on the manufacturing process, the substrate 114 is adjacent to the anode 111 as illustrated in figure 5 to 11, or to the cathode 110 as illustrated in figure 2a and 2b.

The substrate 114 is rigid or flexible. When it is rigid, in a non-limitative embodiment, the substrate 114 is made of glass. It can be PMMA (Polymethyl Methacrylate) material or PC (Polycarbonate) material. By rigid or flexible, one means in the range of applicability. In the non-limitative example of the automotive domain, the range is between -40°Celsius to +150°Celsius. When it is flexible, in a non-limitative embodiment, the substrate 114 is made of a Polyamide material.

By using a thermoforming process, it permits having a 3D shape and it permits adaptation to curve shape or a volume of an element of the vehicle. It is to be noted that PMMA or PC materials can be heat up till it is flexible. Then, the thermoforming process is made. And, once it goes back to normal/range temperature, the material becomes rigid again.

When there is a plurality of QLeds 11 within a segment 10, in a non-limitative embodiment, there are at least two substrates 114 on which the different QLeds 11 are distributed. In a variant of embodiment, there are as many substrates 114 as the number of QLeds 11. In another non-limitative embodiment illustrated in figure 2c, there is only one substrate 114 for all the QLeds 11. This other embodiment reduces cost, complexity and time manufacturing.

In the same manner, when there are a plurality of segments 10, in a non-limitative embodiment, there are at least two substrates 114 on which the different segments 10 are distributed. In a variant of embodiment, there are as many substrates 114 as the number of segments 10. In another non-limitative embodiment illustrated in figures 3 and 4, there are only one substrate 114 for all the segments 10. This other embodiment reduces cost, complexity and time manufacturing.

### Driver 13:

The driver 13 is illustrated in figures 2a to 4, and 10 and 11.

The driver 13 is a multichannel driver. Each channel c is in charge of controlling at least one QLed 11 individually. Hence, each channel c can control one or a plurality or the total QLeds 11 of one segment 10, or a plurality of segments 10, one channel c being configured to apply an electrical power P for the control. Hence, the driver 13 is configured to control each QLed 11 by applying an electrical power P so that the QLed 11 generates said monochromatic light beam b.

The electrical power P depends on the surface/area to cover with the segment(s) 10. In a non-limitative embodiment, the electrical power P=lxV, with I a current and V a voltage. We talk about the density of current per area (I/A). Hence, in a non-limitative embodiment, the current I is within the range of microAmps to milliAmps per area. In a non-limitative embodiment, , the QLED is controlled by constant current I. In a non-limitative embodiment, the V is in the range between 0V and 20V. In a non-limitative variant of embodiment, the V is in the range between 0V and 5V.

When there is only one segment 10 with a plurality of QLeds as illustrated in figure 2b and 2c, the QLed 11 of the segment 10 can be activated and deactivated (aka switch on and switch off):
- independently from another QLed 11 of the segment 10, or
- simultaneously.

As illustrated in the non-limitative example of figure 2a, one has only channel c to apply one electrical power P to control all the QLeds, here the three QLeds 11₁, 11₂, 11₃ of the segment 10. As illustrated in the non-limitative example of figure 2b and 2c, one has one channel c for each QLed 11, here three channels c₁, c₂, c₃ to apply respectively three electrical powers P₁, P₂, P₃ to control respectively the three QLeds 11₁, 11₂, 11₃ of the segment 10. In another non-limitative example not illustrated, one has one channel c for one set of QLeds 11 (for example 11₁) and one channel c for another set of QLeds 11 (for example 11₂ and 11₃), one set comprising one or a plurality of QLeds 11.

When there are a plurality of segments 10 and when each segment 10 comprises only one QLed 11, the QLed 11 of each segment 10 can be activated and deactivated (aka switch on and switch off) :
- independently from the QLed 11 of another segment 10, or
- simultaneously.
In other words, the segments 10 are controlled individually or at the same time.

When there are a plurality of segments 10 and when each segment 10 comprises a plurality of QLed 11 as illustrated in figure 3 and 4, the QLed 11 of one segment can be activated and deactivated (aka switch on and switch off) :
- independently from the other QLeds 11 of the same segment 10 and from the QLeds 11 of the other segments 10, or
- simultaneously with the other QLeds of the same segment 10, and/or
- simultaneously with some QLeds of the other segments 10 .

In the non-limitative example of figures 3, one has three different channels c₁, c₂, c₃ etc. to apply respectively different electrical powers P₁, P₂, P₃ etc. to control respectively the QLeds, here 11₁, 11₂, 11₃, 11₄, 11₅, 11₆ and 11₇, 11₈, 11₉ of the three segments 10₁, 10₂, 10₃. For the sake of clarity of figure 3, the electrical powers P applied to the QLeds 11₄, 11₅, 11₆ and 11₇, 11₈, 11₉ are not illustrated. In the non-limitative example of figures 4, one has three channels c₁, c₂, c₃ to apply three electrical powers P₁, P₂, P₃ to control respectively the three segments 10₁, 10₂, 10₃ In another non-limitative example not illustrated, one can have one channel c for one set of segments 10 (for example 10₁) and one channel c for another set of segments 10 (for example 10₂ and 10₃), one set comprising one or a plurality of segments 10.

If all the segments 10 are controlled altogether, one needs only one channel c for the whole segments 10 to apply only one electrical power P.

Hence, depending on the result one wants to achieve, any combination is possible. In summary :
- the QLeds 11 of a same segment 10 can be controlled individually either by the same electrical power P or individually by different electrical powers P,
- the QLeds 11 of different segments 10 can be controlled individually either by the same electrical power P or individually by different electrical powers P.

The individual control permits having an animated pattern. Hence, depending also of the lighting functionality and colors that are needed, one can choose to activate the QLeds 11 or segments 10 in any chosen combination.

In a non-limitative embodiment, the electrical power P applied on said at least one segment 10 is modulated according to a PWM modulation.

When the segment 10 has only one QLed 11, the PWM modulation allows to define the intensity of the color of the monochromatic light beam b generated by the QLed 11.

When the segment 10 has a plurality of QLeds 11, the PWM modulation allows to define the same intensity or different intensities of the colors of the different monochromatic light beams b respectively generated by the different QLeds 11, and thus to define the desired color(s). Thus, a color tuning can be performed with the PWM modulation. One can have different variations of colors R, G B or colors composed of any combination of R, G, B colors ; it permits adjustment of the proportion of the R, G and B wavelengths to obtain a desired color or different desired colors.

In a non-limitative example, one has the following PWM modulation with RGB QLeds 11:
- R : 255, G: 255, B : 0 to obtain the yellow color. Hence, one puts more intensity on the R and G ;
- R : 255, G : 0, B : 255 to obtain the magenta color. Hence, one puts more intensity on the R and B ;
- R : 0, G : 255, B : 255 to obtain the cyan color. Hence, one puts more intensity on the G and B.

255 is a 100% duty cycle, the maximum of 8-bit value being 255.

In a first non-limitative embodiment illustrated in figure 3, the driver 13 is independent from the substrate 114. In this case, it is supported by an additional substrate 14. In a non-limitative embodiment, said additional substrate 14 is a Printed Circuit Card Assembly, referred to as PCBA.

In a second non-limitative embodiment illustrated in figure 4, the driver 13 is integrated in this substrate 114. In this case, there is no need for an additional substrate. Thus, the number of harnesses to be used as interconnections between the driver 13 and the QLed(s) 11 is reduced. Moreover, one obtains higher robustness relating to disturbance signals and electromagnetic compatibility (EMC). And also there is less cost for manufacturing and process as only one substrate is used.

It is to be noted that the carrier transport layers 112 and the QDs layer 113 have nanometric thickness so we can't see them with the naked eye. We can see through these layers and through the substrate 114 if the substrate 114 is translucent or transparent. These layers are highly transparent or translucent. If the anode 111 and the cathode 110 are both transparent or translucent, the light can go to both selective directions d₁ and d₂ as above mentioned. If the driver 13 is off, that is to say, it doesn't apply any electrical power P on the QLed(s) 11, one can see through the segments 10 of the lighting device 1. Hence, one can see behind the segments 10 where the segments 10 are placed on. The full transparent or full translucent characteristic is interesting in displays or headlamp/rearlamp, as one can see through it when the lighting device 1 is switched off. The global light beam F appears when you switch on the lighting device 1.

### Decorative element 16

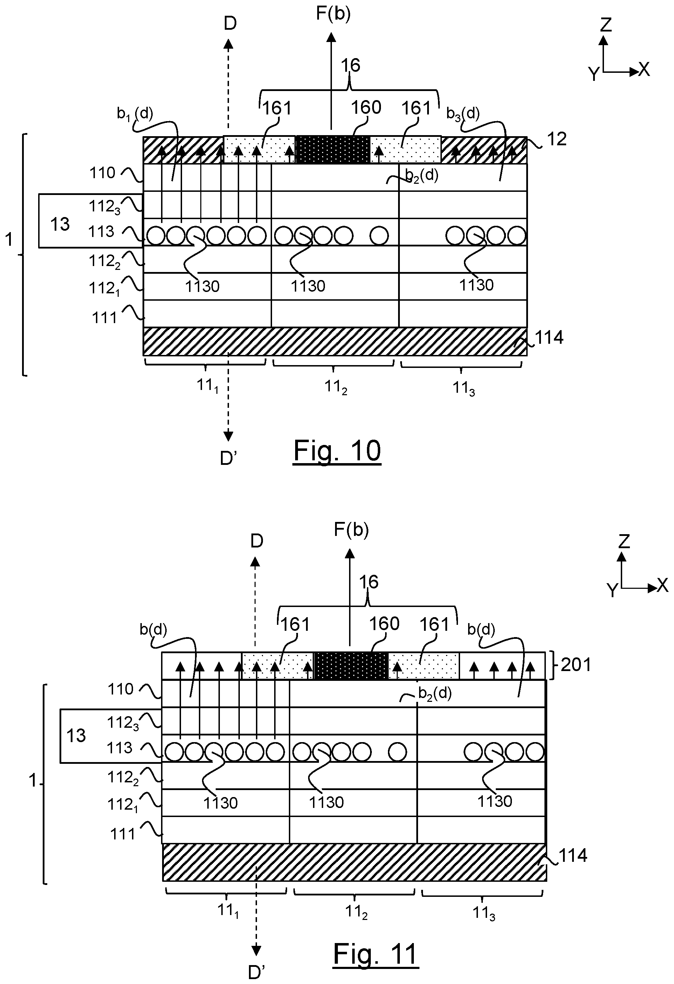

The decorative element 16 is illustrated in figures 10, 11 and 13.

In a non-limitative embodiment, the lighting device 1 further comprises a decorative element 16 or is directly adjacent to a decorative element 16.

The decorative element 16 is an added decorative material that acts as a mask to create a final shape or final pattern to be observed by an observant external to the vehicle. In a non-limitative example illustrated in figure 12, the final geometrical pattern is a logo referred to as AUNM and three curved shapes.

In non-limitative embodiments, the decorative element 16 is printed, overmolded, or stacked. As illustrated in figure 10 and 11, it comprises opaque parts 160 which form decorative areas, and transparent or translucent parts 161 or open areas instead of the transparent or translucent parts. The transparent or translucent parts 161 or open areas are able to let the light pass through.

It is to be noted that in regards to the opaque parts 160 of the decorative element 16, as illustrated in figures 10 and 11, there is no need to have QDs in the normal projection of the opaque parts 160, as one do not need to illuminate those opaque parts 160 which form the decorative areas.

In a non-limitative embodiment, the decorative element 16 is made of PC material. The decorative element 16 is directly adjacent to a part of the lighting device 1 where the light goes out. The decorative element 16 is directly adjacent to the cathode 110 in the example of figure 10.

In a first non-limitative embodiment, the decorative element 16 is adjacent to the lighting device 1 and is integrated in the carrier 201 of the lighting module 20 as illustrated in figure 11, or is adjacent to the lighting device 1 and is added as an additional part of the lighting module 20 as illustrated in figure 13. In this case, in a non-limitative embodiment, one adds this additional part to be sticked, injected or thermoconformed just over the QLEDs 11. Hence, this additional part might be used as an encapsulation layer to protect the QLEDs 11 from environmental conditions like temperature, humidity to avoid oxidation, delamination etc.

In a second non-limitative embodiment illustrated in figure 10, the decorative element 16 is part of the lighting device 1. In a non-limitative variant of embodiment, the decorative element 16 is integrated in the substrate 114 or added as an additional layer of the lighting device 1. It permits creating directly the decorative element 16 in the lighting device 1. There is no need to add extra elements. This additional layer can be deposited (using different deposition techniques like printing, spin coating, inkjet printing etc.), here just over the cathode 110. Hence, this additional part might be used as an encapsulation layer to protect the QLED 11 from environmental conditions like temperature, humidity to avoid oxidation, delamination etc.

Hence, with the different elements of the lighting device 1 above described, the lighting device 1 is able to produce the global light beam F that emerges from the lighting device 1 with at least one color, in particular in the visible RGB spectrum.

Hence, the global light beam F is formed of one or a plurality of different light beams b according to one or a plurality of colors. When it is formed of a plurality of different light beams b according to a plurality of colors, said colors can be equal or different.

In the first non-limitative embodiment of the lighting device 1 illustrated in figure 2a, the global light beam F is composed of one light beam b.

In the second non-limitative embodiment of the lighting device 1 illustrated in figure 2b, the global light beam F is composed of three light beams b1, b2 and b3.

In the non-limitative example illustrated in figure 12, with the global light beam F, the exterior observer can see a multicolor geometrical pattern composed of an illuminated logo "AUNM" and of three adjacent curved shapes illuminated respectively in Red "R", Green "G" and Blue "B". The logo AUNM is composed with many independent segments 10, and each curved shape is composed of adjacent segments 10.

It is to be understood that the present invention is not limited to the aforementioned embodiments and variations and modifications may be made without departing from the scope of the invention. In this respect, the following remarks are made. All statements herein reciting principles, aspects, and embodiments of the invention, as well as specific examples thereof, are intended to encompass equivalents thereof.

Hence, some embodiments of the invention may comprise one or a plurality of the following advantages:
- it permits to have a better optical efficiency : indeed, for the light, one obtains a direct light without a diffuser, a lightguide, optical cones as the prior art,
- it permits to have a better efficiency in terms of power consumption ; indeed, as the optical efficiency is higher, there is no losses of light, then one needs less power for the lighting device,
- it permits to remove many elements such as the diffusive foil, the lightguide, the optical cones, the bezel carrier of the prior art ; thus, the lighting device of the invention is lighter and less expensive, and easier to manufacture,
- the lighting device of the invention is also less expensive to manufacture than this prior art, as QDs deposition is easier, faster and less expensive than a thermoform process for the diffusive foil,
- it permits color tuning with the PWM modulation,
- with a plurality of segments 10, it permits to cover large surface/area,
- it permits to obtain an homogeneous global light beam F,
- it permits to obtain a final (multicolor or unicolor) geometrical pattern which can be animated by switching off and on one or a plurality of parts (aka the segments 10) of the final geometrical pattern,
- the easiness of QDs deposition allows to create endless of RGB patterns directly on different layers of the lighting device 1,
- it permits to have a higher color gamut of RGB than the prior art that uses RGB light sources or laser light source, thanks to the QDs, as the QDs layer(s) 113 offers a purest color than native RGB light sources; indeed, with a QDs layer 113 the light spectrum is more narrow due to a lower value of FWHM ("Full Width at Half Maximum" parameter than the one of the RGB light sources. Therefore, the light spectrum of the QDs layer(s) 113 is purer. It means that in the CIE color diagram known by the man skilled in the art, it is possible to select more purer RGB color points. Therefore, one can form a wider triangle which means that one can select more colors (in fact all colors inside said triangle) compared to other technologies such as the RGB light sources whose triangle is smaller,
- It permits to select one or two directions for the monochromatic light beam(s) b, and thus for the emergent light beam F.

## Claims

1. Lighting device (1), wherein said lighting device (1) comprising :
- at least one segment (10) comprising at least one QLed (11), said at least one QLed (11) being configured to generate a monochromatic light beam (b) and being composed of one cathode (110), one anode (111), carrier transport layers (112), at least one active Quantum dots layer (113), and one substrate (114),
- one driver (13) that is configured to control said at least one QLed (11) by applying an electrical power (P) so that said at least one QLed (11) generates said monochromatic light beam (b).

2. Lighting device (1) according to claim 1, wherein said at least one segment (10) comprises a plurality of QLeds (11).

3. Lighting device (1) according to claim 2, wherein said at least one segment (10) comprises three QLeds (11).

4. Lighting device (1) according to claim 2 or 3, wherein each QLed (11) is configured to generate a monochromatic light beam (b) of a same color of all the other QLeds (11), or a monochromatic light beam (b) of a different color of at least another QLeds (11).

5. Lighting device (1) according to any of the preceding claims 2 to 4, wherein the monochromatic light beams (b) are a combination of blue, red, and/or green, or a combination of yellow, magenta, and/or cyan.

6. Lighting device (1) according to any of the preceding claims, wherein said lighting device (1) comprises a plurality of segments (10) with at least one QLed (11) or a plurality of QLed (11).

7. Lighting device (1) according to the preceding claim, wherein the driver (13) is a multichannel driver, each channel (c) being configured to control at least one QLed (11) individually.

8. Lighting device (1) according to any of the preceding claims, wherein said monochromatic light beam (b) is generated in at least one selective direction (d), said at least one selective direction (d) depending on the material(s) of the cathode (110) and anode (111).

9. Lighting device (1) according to any of the preceding claims, wherein the cathode (110) and the anode (111) are of the same material or are of different materials.

10. Lighting device (1) according to the preceding claim, wherein the material(s) is a transparent or translucent material(s), or an opaque material(s) or a reflective material(s).

11. Lighting device (1) according to any of the preceding claims, wherein the electrical power (P) applied on said at least one segment (10) is modulated according to a PWM modulation.

12. Lighting device (1) according to any of the preceding claims, wherein said driver (13) is integrated in said substrate (114).

13. Lighting device (1) according to any of the preceding claims, wherein said lighting device (1) further comprises a decorative element (16) to form a pattern or is directly adjacent to a decorative element (16).

14. Lighting module (20), said lighting module (20) comprising a lighting device (1) according to any of the preceding claims, a housing (200) that is configured to house said lighting device (1), and a carrier (201).

15. Lighting module (20) according to the preceding claim, wherein said lighting module (20) is a lamp of a vehicle, or a dashboard lighting module of a vehicle, or an interior element of a vehicle.
